# EUROPEAN PATENT APPLICATION

(11) **EP 4 160 917 A1**
(43) Date of publication of application: **05.04.2023**
(21) Application number: 21306380.3
(22) Date of filing: 01.10.2021
(51) Int. Cl.: H03H 9/02

(54) **ACOUSTIC WAVE DEVICE**

(71) Applicant: Université de Franche-Comté, 25000 Besançon (FR); Centre national de la recherche scientifique, 75016 Paris (FR)
(72) Inventor: HAMIDULLAH, Muhammad, Besançon (FR); LEBLOIS, Thérèse, Besançon (FR); ELIE-CAILLE, Céline, Cubrial (FR)
(74) Representative: Office Freylinger

(57) **Abstract**

The invention proposes an acoustic wave device comprising a piezoelectric member with at least one electrode arrangement on a first face thereof configured to generate in said piezoelectric member, when an exciting electrical signal is applied, Lamb waves having a predetermined wavelength, said piezoelectric member having a thickness, h, between the first and an opposite second face.

The height, h, of the piezoelectric member is greater than the wavelength λ of the generated Lamb waves, where a ratio h/λ is such that a phase velocity vₚₕ of high order modes is below the phase velocity of fast shear bulk acoustic waves (fast-SBAW), thereby exciting high-order mode Lamb waves with quasi-zero surface components, QZ-PAW.

The invention is suitable for application in electronics and telecom (delay lines, resonators) and in biosensor.

## Description

### FIELD OF THE INVENTION

The present invention generally relates to acoustic wave devices and more specifically to an acoustic wave device based on plate acoustic waves.

### BACKGROUND OF THE INVENTION

Acoustic wave devices, in particular surface acoustic wave devices, are used in a variety of applications: filters, resonators oscillators, etc. in electronics/telecom, as sensors in liquid media, e.g. bio-chemical sensor, or temperature, flow and pressure sensor...

An acoustic wave device typically employs a piezoelectric plate member with one or more electrodes configured to convert electrical signals to acoustic waves and vice versa, by exploiting the piezoelectric effect.

Several types of acoustic waves (AW) devices have been extensively studied and reported for sensor application in liquid media [REF 1]. The main aim is to prevent or minimize the radiation of acoustic energy into the liquid media. In general, AW can be classified into three different categories: bulk acoustic waves (BAW), surface acoustic waves (SAW) and plate acoustic waves (PAW). BAW-based devices with in-plane components polarization such as QCM[REF 2], lateral field excitation BAW [REF 3], and shear mode TFBAR [REF 4], for example, are suitable for a sensor in liquid media by having close-to-zero out-of-plane displacement component at the surface, thus preventing the conversion of acoustic energy into longitudinal pressure wave in the liquid. Similarly, several types of SAW are suitable for a sensor in liquid media, such as SH-SAW [REF 5] and Love mode (LM) [REF 6] and HVPSAW [REF 7].

The radiation of acoustic energy into the liquid can also be prevented by using the AW with phase velocity, vₚₕ, lower than the compressional sound velocity of liquid media (1500 m/s in water, for instance). For PAW-based sensors in liquid media, this condition can be achieved by using the fundamental antisymmetry Lamb wave (Ao) mode [REF 8]. However, it is limited only at a low plate thickness to wavelength ratio (h/λ), typically at an h/λ ratio lower than 0.1. Consequently, making the device very fragile or, if a thicker plate is used, a larger wavelength is necessary, thus lowering the operating frequency. Gao et al. reported the use of the mass-loading technique by using a high aspect ratio electrode to reduce the velocity of the waves lower than the velocity of the liquid with a trade-off in the reduction of electromechanical coupling coefficient and the complexity of the fabrication process to obtain high aspect ratio electrode [REF 9].

PAW based devices have an advantage over SAW for sensor application in liquid media as they have two free surfaces that are both sensitive to surface perturbations. Thus, when the interdigital transducer (IDT) is employed to convert the electrical energy into acoustic waves and vice versa in one of the surfaces, the opposite surface can be used as the sensing layer. Thus, the electrical connection is separated from liquid contact without requiring an additional thin dielectric layer covering the IDT. Several types of PAW have in-plane polarization, such as SH-APM [REF 10] and symmetric Lamb modes [REF 11]. For fundamental symmetry Lamb wave (So) mode, dominantly longitudinal displacement condition is also achieved at a low h/λ ratio. Therefore, it has a similar limitation as A₀ mode in terms of the robustness of the device.

While AW type with in-plane polarization minimizes the acoustic energy radiation, the loss of acoustic energy is still occurring due to the penetration of in-plane particle displacement and the wave-liquid interaction length at the solid/liquid interface. Due to non-zero in-plane particle displacement at the solid surface, or even in most cases are maximum at the surface, the in-plane particle displacement exponentially decreases to zero in the liquid. The thin liquid layer at the solid/liquid interface, where the liquid is coupled to the oscillating surface of the plate, is called the characteristic penetration depth or a decay length δ [REF 12]. The insertion loss will increase as the liquid viscosity increases. Therefore, the magnitude of insertion loss can be used to quantify the liquid viscosity. However, when the liquid viscosity is very high, the significant reduction in the signal strength affects the signal-to-noise ratio and the quality factor of the sensor, and consequently, the sensor's sensitivity. Additionally, the insertion loss will further increase when the sensor has a higher operating frequency, limiting the maximum operating frequency of the AW-based sensor application in liquid media.

### OBJECT OF THE INVENTION

It would be desirable to have an acoustic wave device with even further reduced wave liquid interaction and hence less insertion loss.

This object is achieved by an acoustic wave (AW) device as claimed in claim 1.

### SUMMARY OF THE INVENTION

The present invention is based on the present inventors' research, who have identified a novel type of higher-order plate acoustic waves with close-to-zero particle displacement at the surface of the piezoelectric plate, thus reducing the wave-liquid interaction length and the insertion loss.

According to the present invention, an acoustic wave device comprises a piezoelectric member with at least one electrode arrangement on a first face thereof, the piezoelectric member having a thickness between the first and second face. The excitation electrode arrangement is provided on a first face of the piezoelectric member to generate in the piezoelectric member Lamb waves having a predetermined wavelength λ. The electrode configuration conventionally determines the wavelength λ.

According to the invention, the acoustic wave device is configured such that application of an exciting electrical signal (typically alternating voltage creating electric field) to the electrode arrangement excites high-order mode Lamb waves with quasi-zero surface components, the piezoelectric member being configured with a height, h, greater than the wavelength of the generated Lamb waves, and a ratio h/λ being such that a phase velocity vₚₕ of high order modes is below the phase velocity of fast shear bulk acoustic waves.

The present invention thus proposes an acoustic wave device designed to generate and propagate plate acoustic waves (PAW) with close-to-zero surface displacement relative to the maximum displacement inside the solid-state substrate. In the following, these modes are also noted QZ-PAW.

In the inventive device, the acoustic energy of the QZ-PAW propagates and is concentrated in the center of the substrate. Since the QZ-PAW travel at the center of the piezoelectric member, the radiation of acoustic energy to the surrounding media will be minimized, and the insertion loss reduced.

As will be explained in detail below, the inventors have discovered that under certain conditions, namely at high h/λ ratio, the phase velocity of high order LW modes converge into vₚₕ of (fast) shear bulk acoustic waves (SBAW), whereby elliptically polarized LW convert into QZ-PAW. QZ-PAW have been confirmed by simulation and the concept of AW devices implementing QZ-PAW have been validated experimentally.

The QZ-PAW have very low, namely quasi-zero, surface displacement, which means low total displacement (u₁+ u₂+ u₃₎ at the surface. In the context of the invention, QZ-PAW modes have, by definition, less than 10%, preferably less than 5%, total surface displacement over maximum total displacements inside the piezoelectric member. In addition to a low total displacement, the QZ-PAW with the lowest insertion loss has a dominantly longitudinal displacement component (u₁₎ at the surface, with (u_{1/} u₃) ratio of higher than 1.

As will be clear to those skilled in the art, the piezoelectric member used in the invention is rather thick (h/λ ratio > 1), and its excitation by the electrodes will also generate other conventional LW modes. The present AW device may thus be considered as a multi-mode AW device with QZ-PAW.

The piezoelectric member may have any appropriate shape and properties to meet the requirements for exciting and propagating QZ-PAWs. The piezoelectric member normally has two opposite surfaces or faces, and may thus generally have a plate-like shape. The opposite faces are normally parallel and flat.

Conventionally, the piezoelectric member includes a plate-like substrate having two parallel opposite faces. The plate-like substrate is a crystal that forms the main element of the piezoelectric member, in which the waves generated by means of the input electrode arrangement will propagate. This plate-like substrate may have a rectangular/parallelepiped shape, or disk shape, or other.

In embodiments, the piezoelectric member includes or consists of a plate substrate of piezoelectric material (normally a monolithic crystal plate). If desirable, a piezoelectric layer can be deposited on the piezoelectric substrate to enhance the piezoelectric effect (e.g. a layer of ZnO on a GaAs plate).

Alternatively, the piezoelectric member may include a non-piezoelectric plate substrate, having at least one face covered by a layer (thin film) of piezoelectric material. For example, the piezoelectric member can comprise a non-piezoelectric substrate having two opposite parallel faces, where one of these faces supports a (ultra) thin layer of piezoelectric material, or both faces. The design of such layer/thin film is such that it shall permit acting as transducer to excite the non-piezo substrate, however without significantly affecting the type of the modes and the displacement profile of the modes therein .

Where desirable, as indicated above, the piezoelectric member may include additional piezo layers, or other layers as may be suitable for various functions, as known in the art. For example, one may deposit a protective layer over the face bearing the electrode layers. Multilayered structures may also be used for temperature compensation, for example.

Whatever the structure of the piezoelectric member, it is mounted, in practice, to have two opposite free faces/surfaces and the thickness h is the distance between these two opposite free surfaces.

In general, the piezoelectric member, respectively plate substrate, may have a thickness of up to 1 mm (for example between 1 and 1000 µm).

The AW devices include one or more electrode arrangements, depending on the intended application. The electrodes are generally designed as transducers configured to convert an electrical signal into acoustic waves and inversely. Conventionally, the design of the electrode arrangement that receives the exciting voltage will determine the wavelength λ of the excited Lamb waves. The electrode arrangement may be conveniently realized as a pattern of interdigitated transducer (IDT), where two comb-shapes electrodes have fingers meshing with each other. The distance/pitch between two neighboring fingers of one comb-shaped electrode corresponds to the wavelength λ. Electrodes may e.g. be made from aluminium or gold.

The piezoelectric member may use any plate-like substrate (monolithic crystal plate) capable of supporting QZ-PAW. The plate-like substrate is advantageously cut out at an angle allowing excitation of the QZ-PAW. Preferably, the plate substrate has an Euler crystal cut angle of 0, 0, α, where α is between 0 and 90°.

Advantageously, the plate substrate is conventionally prepared such that wave propagation occurs in a known direction. Crystal orientation is known from the crystal growth technology. In embodiments, the wave propagation direction is (110) and two electrode arrangements (input / output) are spaced from each other, aligned along this wave propagation direction. The direction is advantageously determined to obtain the maximum electromechanical coupling coefficient, and also in this case to obtain the lowest surface displacement.

In the case of a piezoelectric substrate, cubic, tetragonal or orthorhombic crystal structures are preferred.

For non-piezo substrates, possible cubic structured materials are (without limitation) silicon, germanium, diamond, etc.

For piezoelectric members configured as thin film piezoelectric layer(s) on a non-piezo substrate, the piezoelectric layers may e.g. comprise or consist of ZnO, AIN, AIScN, PZT, BN, PMN-PT, LiNbO₃ or BaTiO₃. Such piezoelectric layers may be deposited by any appropriate technique, e.g. Chemical Vapour Deposition (CVD), Physical Vapour Deposition (PVD), Atomic Layer Deposition (ALD), Pulsed laser deposition (PLD), Molecular Beam Epitaxy (MBE) and Chemical Solution Deposition (CSD).

The present AW device can be manufactured by any appropriate technique. It may be noted here that the inventive AW device can be manufactured using existing techniques in the fields.

The manufacturing process may be simpler (more flexible) than for conventional AW devices, since a relatively thicker plate is used, i.e. less fragile. Also, since the QZ-PAW travel inside the plate below the surface, they are not affected by the surface roughness of the piezoelectric member/substrate. Accordingly, the free faces of the piezoelectric member/substrate may have a roughness in the order of 1 nm to 10 µm, or 5 nm to 5 µm.

As will be clear to those skilled in the art, appropriate configurations of the piezoelectric member to excite QZ-PAW, in particular in terms of dimensions, electrode configuration, h/λ ratio and cut angle, can be determined by simulation.The present AW devices constitutes a micro-electro-mechanical system (MEMS) that may find application in a variety of domains, in particular electronics / telecommunications for Ultra-high frequency applications, or in the field of biosensors.

In practice, the present AW device is built such that the piezoelectric member is mounted on a support so that its two opposite faces are free, e.g. fixed at its edges.

The present AW device may be integrated in a system with control unit configured to apply an electric input signal to the electrode arrangement and measure an output signal in order to evaluate at least one parameter of a high-order mode Lamb wave with quasi-zero surface components, QZ-PAW.

The control unit may be configured to evaluate changes of at least one of a phase shift, frequency shift, time delay and phase velocity shift of the output signal relating to a high-order mode Lamb wave with quasi-zero surface components.

Technical implementation of AW systems based of such piezoelectric devices are known in the art and usual techniques are compatible. The critical aspect is here to design the piezoelectric member such that it meets the requirements described herein to obtain QZ-PAW.

In the electronics and telecom field, the present AW device may be configured to operate as resonator, filter, oscillator, delay line, in particular as one port resonator, reflective delay line one port resonator or two port delay line.

The present AW device may also be used in a sensor system, in order to measure non-surface sensitive parameters, such as e.g. temperature, pressure or strain/torque. Indeed, changes of temperature, pressure and strain will have an effect on the crystal structure of the piezoelectric member/substrate and hence affect the resonance of QZ-PAW modes.

The fact that QZ-PAW are non-surface waves and hence not affected by surface interactions is of advantage for UHF applications. State of the art UHF AW devices (delay lines, resonators, etc.) require vacuum packaging in order to prevent acoustic energy radiation to air. Vacuum packaging is not required with the inventive AW device, since QZ-PAW do essentially not have surface components.

In the case of biosensors, the surface effects can be measured by means of the other Lamb wave modes with surface components, e.g. in-plane polarized modes. The QZ-PAW can be advantageously used as a reference signal: where a change of the measuring mode (e.g. in-plane polarized) occurs together with a change of the reference mode (QZ-PAW), this will indicate that the change of measuring mode is not only due to surface effects, but also e.g. to a change in temperature.

As will be understood by those skilled in the art, the design of the AW device may be done with the help of simulation (finite element method simulation), which is one of the numerical methods to study the acoustic wave propagation and to obtain the velocity and/or the resonance frequency of Lamb waves. It is also possible to obtain the solution of wave propagation analytically or numerically using programming software such as Matlab.

Regarding acoustic wave propagation (and Lamb wave propagation in particular), Lamb wave dispersion is well known (Lamb waves velocity is dependent on wave vector, frequency and thickness/wavelength ratio - see e.g. [REF 13-16] for Lamb wave characteristic equations or determination of dispersion curves with COMSOL simulation). In the context of the invention, the dispersion curves of Lamb waves in a "thick plate" show that the fundamental modes (Ao and So) will approach the Rayleigh wave velocity and the higher order mode will approach the shear wave (bulk acoustic wave-BAW) velocity, i.e. the fast SBAW.

Based on the dispersion curves, the skilled person will thus be able to select the appropriate design of piezoelectric member, namely the appropriate h/λ ratio, to that the QZ-PAW may exist. That is the piezoelectric member is designed such that a solution of Lamb wave may exist, with velocity around the fast-SBAW, where the displacement profile across the plate is quasi-zero at the surface of the plate, and the maximum displacement is inside the plate. Conventionally, in addition to the ratio h/λ, parameters that may be adapted are material choice, crystal cut, and direction of propagation.

The above and other embodiments of the invention are recited in the appended dependent claims.

According to another aspect, the invention also relates to an acoustic wave system as claimed in claims 11 and 12.

According to yet another aspect, the invention also relates to an acoustic wave system as claimed in claim 13.

According to still aspect, the invention also relates to a method of operating the present acoustic wave device.

### BRIEF DESCRIPTION OF THE DRAWINGS

The present invention will now be described, by way of example, with reference to the accompanying drawings, in which:
Figure 1: is a principle perspective view of an embodiment of the present acoustic wave device;
Figure 2: are graphs (a) and (b) of Lamb wave dispersion curves in a piezoelectric plate (b); (c) are principle views representing the QZ-PAW displacements of the first three higher-order modes in a substrate;
Figure 3: are graphs illustrating (a) the ratio between total displacement at the surface of the plate and the maximum displacement inside the plate (u_{surf}/uₘₐₓ) and (b) ratio of longitudinal and shear vertical displacements (u₁/u₃) at the surface of the plate;
Figure 4: is a graph (simulation) of the S21 scattering parameter vs. frequency for the present acoustic wave device;
Figure 5: is a principle perspective view of an embodiment of acoustic wave device in contact with liquid media;
Figure 6: is a diagram illustrating displacement profile for three different modes (out of plane polarized, in plane polarized and QZ-PAW) in contact with liquid;
Figure 7: is an experimental graph of the S21 scattering parameter vs. frequency for the present acoustic wave device;
Figures 8 and 9: are principle diagrams of alternative embodiments of the present AW device.

### DETAILED DESCRIPTION OF PREFERRED EMBODIMENTS

The present embodiment will now be explained in detail, in particular with reference numerical simulation (finite element simulation) and to experimental examples.

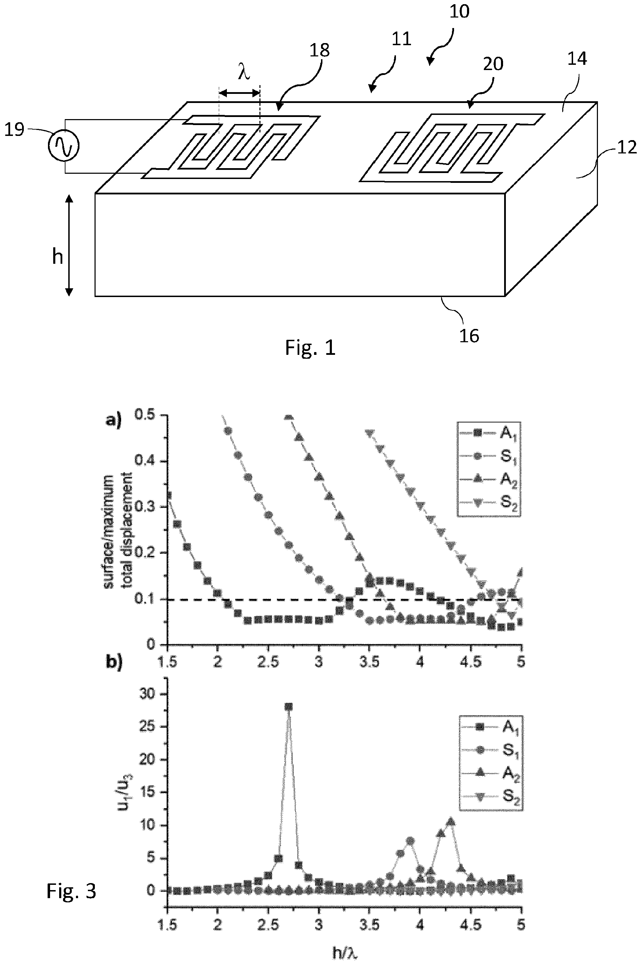

Referring to figure 1, a first embodiment of the present AW device 10 is shown. It comprises a piezoelectric member, generally indicated 11, comprised of a plate-like piezoelectric substrate 12 with two planar opposite faces: an upper, first face 14 and a lower, second face 16. Electrodes are arranged on the upper face 14, a first electrode 18 serving as input electrode whereas the second electrode 20 serves as output electrode. As will be recognized, the electrodes 18, 20 are formed as interdigitated electrodes (or Inter-digitated transducers IDTs) and act as transducers to convert the electrical energy into acoustic waves and vice versa in one of the surfaces.

Reference sign h in Fig.1 indicates the thickness of the piezoelectric plate, i.e. the distance between the two faces 14 and 16. Also to be noted is the distance λ between two neighboring fingers of the same comb-shaped element of electrode 18, which will generate in the plate 12 acoustic waves of corresponding wavelength λ, when an electric signal is applied.

As can be noticed from the figure, the thickness of the piezoelectric plate 12 is greater than the inter-digit distance λ, i.e. the ratio h to λ is greater than 1.

The present device 10 is configured to generate higher-order plate acoustic waves with close-to-zero particle displacement at the surface, QZ-PAW. In practice, various modes of Lamb waves are generated, in addition to the desired acoustic waves with close-to-zero particle displacement at the surface. Accordingly, the inventive device can be referred to as multi-mode plate acoustic wave device with a zero-surface displacement plate acoustic mode.

In practice, the exciting electrode arrangement 18 is connected to a voltage source 19, whereby an alternating voltage is applied to the input electrode 18. A control unit (not shown) is connected to the second electrode arrangement 20, which generates an output signal based on the received acoustic waves. The control unit is typically configured to acquire, evaluate and process the output signal, in particular to analyze its components. The control unit may in particular be configured to monitor the resonance frequency of predetermined modes, inclusive the QZ-PAW, and compare it to reference values.

The device of Fig.1 may typically form a delay line, whereby the distance between the two electrodes 18, 20 is typically a multiple of the wavelength λ. Operation, namely signal analysis, of such delay line is known in the art and will not be detailed herein.

In the embodiment of Fig.1, the piezoelectric member 11 simply consists of a plate-like substrate 12 made of piezoelectric material. This substrate is normally a monocrystal having two opposite faces 14 and 16, and the thickness h is measured between these free faces 14,16.

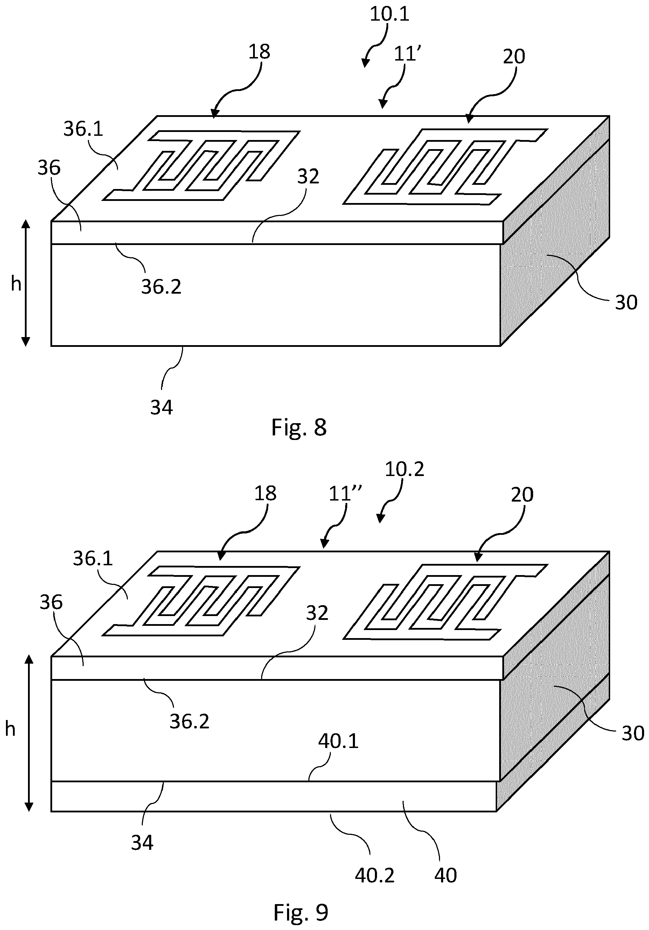

Alternatively, the piezoelectric member may comprise a non-piezo substrate having a layer of piezoelectric material at least on one face thereof, as will be explained with reference to Figs. 8 and 9, showing two alternative embodiments of AW device 10.1 and 10.2.

In Fig.8, the piezoelectric member 11' includes a plate-like substrate 30 of non-piezoelectric material having two opposite face 32 and 34. Substrate 30 may be a cubic centered monocrystalline material such as, e.g., silicon or germanium. The first (upper) face 32 is covered with a thin layer of piezoelectric material 36. The piezo layer 36 is deposited by any appropriate method. The piezo layer 36 may e.g. be a layer of ZnO, AIN, AIScN or PZT. As can be seen, piezo layer 36 has two opposite faces 36.1 and 36.2, where lower face 36.2 is in contact with upper face 32 of substrate 30. The upper face 36.1 of piezo layer 36 is a free surface, which supports the electrode arrangements 18, 20.

Turning to Fig.9, the AW device 10.2 includes a piezoelectric member 11' comprised of a substrate 30 and layer of piezoelectric material layer 36 similar to device 10.1 of Fig.8. A further thin piezoelectric layer 40 is covering the second face 34 of substrate 30. That is, piezo layer 40 has a face 40.1 in contact with bottom face 34 and an opposite free face 40.2.

It may be noted that the thickness h of the piezoelectric member 11' and 11" of Figs. 8 and 9 for computing the ratio h/λ corresponds to the sum of the thicknesses of substrate 30 and piezoelectric layer(s) 36, 40. That is, distance between free faces 34 and 36.1 for AW device 10.1 and free faces 40.2 and 36.1 for AW device 10.2.

### Observations on the inventive principle

Without willing to be bound by theory, the inventor's considerations on the invention and its scientific context are the following.

Lamb waves (LW) are a subset of surface acoustic waves (SAW) that propagate in elastic solid plates with two free surfaces (as opposed to SAW propagation on a free surface of semi-infinite substrate). Originally described mathematically by Horace Lamb as an extension of Rayleigh waves (RW), a general solution of Lamb's characteristic equation in an isotropic and homogenous plate resulting in Lamb wave (LW) dispersion curves with two sets of sinusoidal waves (symmetric Sn and antisymmetric An modes), with two component displacement: longitudinal (in-plane, u₁) and shear vertical (out-of-plane, u₃) displacement, with maximum displacement on the surfaces. For highly anisotropic and piezoelectric substrate, LW might have three component displacements with non-zero shear horizontal (out-of-plane, u₃).

LW is dispersive thus the phase velocity (vₚₕ) is dependent on the frequency and the plate thickness to wavelength (h/λ) ratio. While LW are generally elliptically polarized (with both in-plane and out-of-plane particle displacement), under specific conditions such as LWfundamental symmetric mode at very low h/λ ratio and higher order symmetric modes at the phase velocity close to longitudinal BAW velocity, the solution of LW modes have only u₁ displacement component with in-plane polarization with close-to-zero u₃ displacement component (quasilongitudinal, QL-LW).

As previously mentioned, while in-plane polarized AW-devices could minimize the acoustic energy radiation, however, the loss of acoustic energy still occurs due to the penetration of in-plane particle displacement at the solid/fluid surfaces. The loss may reduce the acoustic waves signal significantly for AW-devices working in highly viscous media or ultra-high operating frequency.

The present invention proposes a device exploiting plate acoustic waves (PAW) with close-to-zero surface displacement (quasi-zero, QZ-PAW), relative to the maximum displacement inside the solid plate. In the present device, the acoustic energy propagates and is concentrated in the center of the plate.

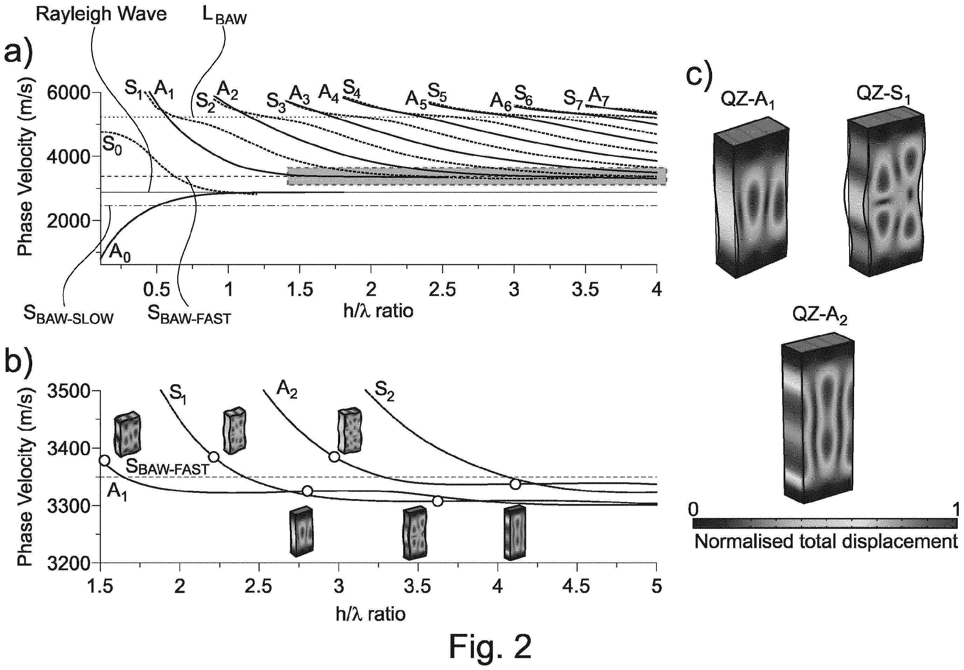

Figure 2a shows the dispersion curves of LW propagating in a piezoelectric plate. The simulation is based on a GaAs plate with a (100) cut and where PAW travel in direction <110>. As shown in figure 2a, the vₚₕ fundamental modes are converging into the vₚₕ of RW, while the vₚₕ of higher order modes are converging into vₚₕ of shear BAW at higher h/λ ratio. The conversion of elliptically polarized LW into QZ-PAW is shown in figure 2b. As shown in figure 2a, the surface displacements are vanishing when the phase velocity is crossing the vₚₕ of shear BAW.

The first three QZ-PAW modes: QZ-A₁, QZ-S₁ and QZ-A₂, are shown in figure 2c. As can be seen, the top and bottom regions are dark grey, which corresponds to zero or quasi-zero total displacements, whereas light grey areas towards the inside of the plate indicate the presence of displacements.

Figure 3a shows the relative total displacement on the surface of the plate to the maximum total displacement inside the plate. As can be seen, the total surface displacements of the modes are reducing to the value of around 5% of the maximum total displacement. The surface total displacements are the lowest at h/λ ratio of 2.3 to 3.1, 3.5 to 4.8, and 3.8 to 4.7 for A₁ S₁ and A₂ modes respectively. Figure 3b shows the u₁/u₃ ratio at the surface of the plate. As shown, the modes are dominantly longitudinal at the surface at h/λ ratio of 2.7, 3.9 and 4.3 for A₁, S₁ and A₂ modes respectively.

The particle displacement components u₁, u₂, and u₃ have been further investigated at h/λ ratio of 2.7, 3.9 and 4.3 for A1, S1 and A2 modes respectively. It appears that the u₃ of the QZ-PAW modes are vanishing to zero at the surface of the plate, while the u₁ of the QZ-PAW modes are around 5% relative to the maximum displacement inside the plate. Thus, the quasi-zero surface displacement is contributed mainly by in-plane particle displacement. The u₂ of the modes are constantly zero across the plate due to the cubic crystal symmetry of GaAs substrate.

With quasi-zero and dominantly longitudinal surface displacement, the radiation of acoustic energy to the surrounding media will be minimized.

The above identified configurations and h/λ ratios are of particular interest in such substrate to operate QZ-PAW modes.

### Experimental validation

### Example 1

The present inventive concept has been experimentally validated. In the experiments, the AW device is designed as two port delay line with a piezoelectric substrate as shown in Fig.1. The piezoelectric plate/substrate 12 of Fig.1 is a piezoelectric (100)-cut GaAs substrate with a thickness h of 625 µm. The comb-shaped electrodes have a pitch λ = 168 µm. Hence the ratio h/λ is 3.7. The waves are propagating at <110> direction (Euler angle ZXZ → 0 0 45).

The IDTs have 50 finger pairs with an aperture of 50λ. The length of the delay line is 200λ so that the centre to centre distance between the transmitter and receiver IDTs (16, 18) is 250λ or equal to 42 mm. 100 nm of aluminium is used as an electrode with 10 nm Cr as an adhesion layer.

Due to its relatively thick substrate, the present AW device will generate multiple LW modes with different polarization at the surface of the plate: out-of-plane polarization, in-plane polarization, and zero-surface displacement (QZ-PAW) as shown in figure 2.

The wavelength λ of the waves of the AW device of figure 1 is defined by design and the periodicity of the input electrode arrangement 18. All modes are excited by the same electrode arrangement 18 thus having the same wavelength (λ). The modes have different resonance frequencies where the resonance frequency is equal to the phase velocity divided by the wavelength.

The present AW device has at least one mode with zero surface displacement.

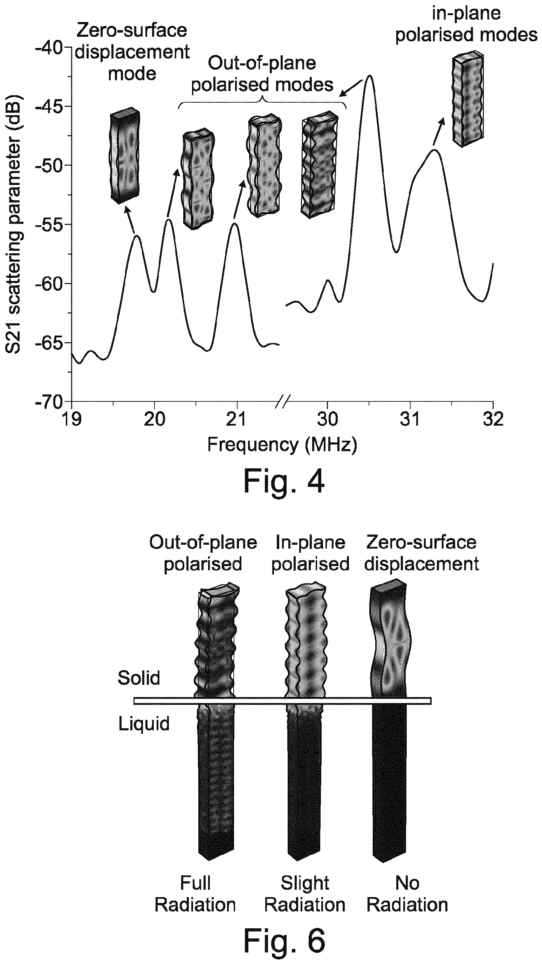

This can be observed on Fig. 4 (determined by FEM simulation), which shows the modelized transmission characteristic of the AW device. The first peak just before 20 MHz corresponds to QZ-PAW modes. The following 3 peaks correspond to three out of plane polarized modes. The last peak corresponds to in-plane polarized modes.

As known from simulation and dispersion curves, the peak of the QZ-PAW mode actually corresponds to the resonance of the three QZ-PAW modes A1, S1 and A2.

This confirms the co-existence of QZ-PAW modes together with other, longitudinal PAW modes.

### Example 2

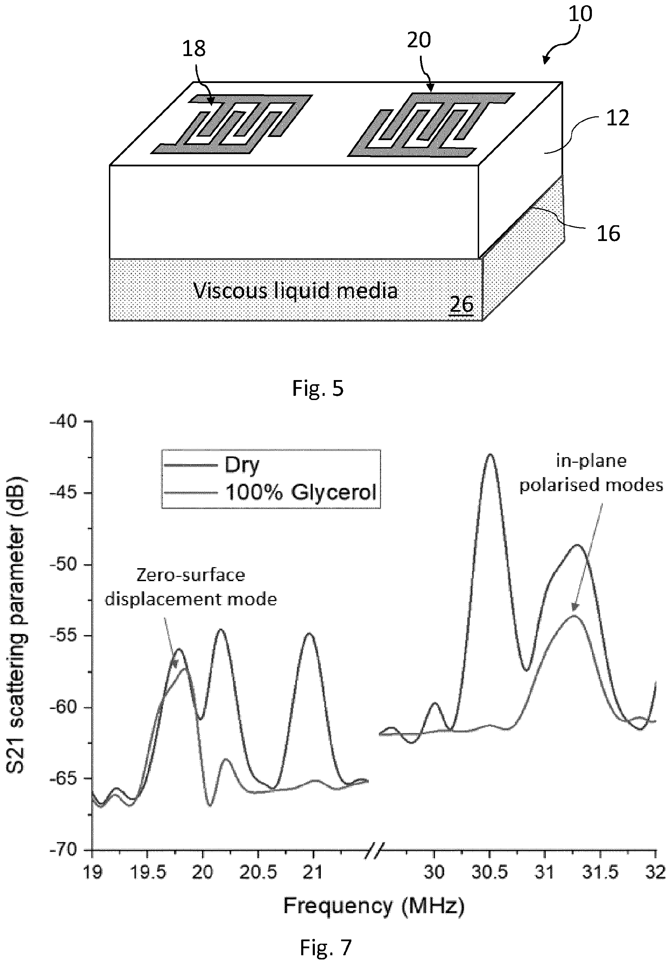

Fig. 5 schematically represents an application of the present AW device in the context of liquid media. In such case, the second face 16 of the AW device 10, opposite the face 14 bearing the electrodes 18, 20, is in contact with a viscous liquid medium 26.

Figure 6 shows the radiation of acoustic energy in the solid/fluid interface. When in contact with viscous liquid media, the acoustic energy of out-of-plane modes are fully radiated into the liquid. In contrast, QZ-PAW modes remain essentially in the solid plate.

Due to the "penetration depth" of in-plane polarized modes particle displacement at the solid/fluid interface, some part of acoustic energy of in-plane modes is radiated into the liquid causing some loss in the transmitted signals (noted S21 signals). The in-plane polarized modes are sensitives to surface perturbation such as the change in the liquid viscosity, liquid mass density, and the mass loading at the surface of the plate. The in-plane polarized modes can be used as a sensor where the change in the signal is due to perturbations of the plate surfaces.

The zero-surface displacement modes are the least sensitive to surface perturbation, with close to zero acoustic energy radiation to the liquid, thus they have the least losses when the surface is in contact with viscous liquid media.

Figure 7 shows the experimental frequency response of multi-mode PAW devices when one of the plate surfaces is in contact with air (dry), line 70, or with highly viscous liquid (100% glycerol), line 72. As shown, the signals of out-of-plane modes are vanishing due to radiation of acoustic energy into the liquid. The reduction of the S21 signals is more than 6 dB for in-plane polarized mode and less than 2 dB for zero-surface displacement mode.

This confirms that QZ-PAW travel essentially inside the piezoelectric plate, without interfering with surrounding media. The present AW device with QZ-PQW modes can thus be used for any type of AW device application such as e.g. one port resonator, two port resonator and two port delay line.

The present AW device can in particular be used in an acoustic wave sensor, for sensing temperature, pressure and torque/strain.

### Manufacturing aspects

It may be noted that to operate the AW devices at higher frequencies, the wavelength of the IDT is reduced. Consequently, the thickness of the plate substrate must be reduced to keep the same ratio between the thickness and the wavelength. Several processes can be used to thin down the plate such as substrate grinding and polishing or by bulk micromachining with physical or chemical etching. When the etching process is used to thin down the plate (such as a SAW grade wafer), the surface of the plate will have some roughness which, as is known, may affect the propagation of the acoustic waves.

As is known in the art, substrates such as wafers are available in the different grades, from 'SAW grade' (< 1nm) to rougher profiles.

Referring to the embodiment of Fig.1, the substrate 12 thickness may have been adjusted by a wet etching process from the second face 16, which may thus have a surface roughness (Rz) in the nm range up to the µm range Due to the surface roughness, the propagations of acoustic waves are perturbed by the scattering of acoustic energy at the rough surface. However, only the mode with zero-surfaces displacement (QZ-PAW) is not affected by the surface roughness.

Due to the fact that the zero-surface displacement mode is not sensitive to any surface perturbation, the signal strength of zero-surface displacement mode is also not affected by the media surrounding the device.

The present AW device thus allows more flexibility in terms of manufacturing, namely less stringent manufacturing processes, since it can operate with rougher surfaces than conventional AW devices. Also, contrary to conventional UHF telecom devices such as delay lines etc, vacuum packaging is not required.

As regards more generally design aspects, as explained before, those skilled in the art will be able to determine the velocity of fast-SBAW for any material, crystal cut, and direction of propagation by solving the Lamb waves characteristic equation, analytically, numerically, or by finite element simulation using FEM software such as COMSOL. Consequently, if the Lamb wave is excited using IDT with a fixed wavelength, they will be able to calculate the expected resonance frequency of QZ-PAW (frequency = velocity/wavelength), this under the conditions prescribed by the present invention.

Furthermore, as shown above, the "expected" resonance frequency of QZ-PAW may be experimentally verified by liquid contact, as it is expected that the QZ-PAW modes will have minimum insertion loss.

### List of Publications

[REF 1] Caliendo C and Hamidullah M 2019 J. Phys. D: Appl. Phys. 52 153001
[REF 2] Auge J, Hauptmann P, Hartmann J, Rösler S and Lucklum R 1995 Sensors and Actuators B: Chemical 24 43
[REF 3] Bienaime A, Liu L, Elie-Caille C and Leblois T 2012 The European Physical Journal-Applied Physics 57 21003
[REF 4] Wingqvist G, Bjurström J, Liljeholm L, Yantchev V and Katardjiev I Sensors and Actuators B: Chemical 123 466
[REF 5] Kondoh J 2013 Electron. Commun. 96 41
[REF 6] Gizeli E, Goddard N J, Lowe C R and Stevenson A C 1992 Sensors and Actuators B: Chemical 6 131
[REF 7] Tong X and Zhang D 1999 Sensors and Actuators A: Physical 78 16.
[REF 8] Zhu Z and Wu J 1995 The Journal of the Acoustical Society of America 98 1057.
[REF 9] Gao F, Al-Qahtani A M, Khelif A, Boussaid F, Benchabane S, Cheng Y, El Agnaf O and Bermak A 2020 IEEE Sensors Journal 21 2725
[REF 10] and Martin S J, Ricco A J, Niemczyk T M and Frye G C 1989 Sensors and actuators 20 253
[REF 11] Zhou L, Wu Y, Xuan M, Manceau J F and Bastien F 2012 Sensors 12 10369-10380.
[REF 12] Ricco, A.J. and Martin, S.J., 1987 Applied Physics Letters 50 1474
[REF 13] Lamb, H. "On Waves in an Elastic Plate." Proc. Roy. Soc. London, Ser. A 93, 114-128, 1917.
[REF 14] Viktorov, I. A. "Rayleigh and Lamb Waves: Physical Theory and Applications", Plenum Press, New York, 1967.
[REF 15] Rose, J.L.; "Ultrasonic Waves in Solid Media," Cambridge University Press, 1999.
[REF 16] Hamidullah, C. Élie-Caille and T. Leblois, "Theoretical study and finite element simulation of ZnO/GaAs higher-order Lamb waves for microsensor application in liquid media," 2020 IEEE SENSORS, 2020, pp. 1-4, doi: 10.1109/SENSORS47125.2020.9278624

## Claims

1. An acoustic wave device comprising:
a piezoelectric member (11) with at least one electrode arrangement (18) on a first face (14) thereof configured to generate in said piezoelectric member, when an exciting electrical signal is applied, Lamb waves having a predetermined wavelength, λ, said piezoelectric member having a thickness, h, between the first and an opposite second face;
**characterized in that** the height, h, of the piezoelectric member (11) is greater than the wavelength of the generated Lamb waves, where a ratio h/λ is such that a phase velocity of high order modes is below the phase velocity of fast shear bulk acoustic waves, thereby exciting high-order mode Lamb waves with quasi-zero surface components, QZ-PAW.

2. The acoustic wave device according to claim 1, wherein said piezoelectric member includes a plate substrate having a cubic, tetragonal or orthorhombic crystal structure.

3. The acoustic wave device according to claim 1 or 2, wherein the plate substrate has an Euler crystal cut angle of 0, 0, α, where α is between 0 and 90°.

4. The acoustic wave device according to claim 1, 2 or 3, wherein the high-order mode Lamb waves with quasi-zero surface components propagate along a predetermined direction, in particular direction (110).

5. The acoustic wave device according to any one of claims 2 to 4, wherein the piezoelectric plate substrate is made from GaAs, GaP, InAs, InP, 3C-SiC, c-BN, PZT, BaTiO₃, PbTiO₃, KNbO3 or Ta₂O₅.

6. The acoustic wave device according to claim 5, wherein the plate substrate is a GaAs substrate having a thickness of up to 1000 µm and the ratio h/λ is greater than 2, in particular greater than 2.5, 3.0, 3.5, or 4.0.

7. The acoustic wave device according to any one of claims 2 to 4, wherein the plate substrate is made from a non-piezoelectric crystal, at least of face of which supports a piezoelectric material layer.

8. The acoustic wave device according to claim 7, wherein the substrate is made from cubic crystalline material, in particular silicon or germanium; and/or the piezoelectric material layer is a deposited thin film layer of ZnO, AIN, AIScN, PZT, BN, PMN-PT, LiNbO₃ or BaTiO₃.

9. The acoustic wave device according to any one of the preceding claims, wherein for said QZ-PAW, the ratio of total surface displacement over maximum total displacements inside the piezoelectric member is less than 10%, preferably less than 5%.

10. The acoustic wave device according to any one of the preceding claims, wherein the first face and/or the second face has a surface roughness in the range of 1 nm to 10 µm.

11. An acoustic wave system comprising the acoustic wave device according to any one of the preceding claims and a control unit configured to apply an electric input signal to the electrode arrangement (18) and measure an output signal in order to evaluate at least one parameter of a high-order mode Lamb wave with quasi-zero surface components.

12. The system according to claim 10, wherein said control unit is configured to evaluate changes of at least one of a phase shift, frequency shift, time delay and phase velocity shift of the output signal relating to a high-order mode Lamb wave with quasi-zero surface components.

13. An acoustic wave system comprising the acoustic wave device according to any one of claims 1 to 10, wherein the acoustic wave system is one of a resonator, filter, oscillator, delay line, a one port resonator, a reflective delay line one port resonator, a two port delay line, biosensor, a temperature sensor, a pressure sensor and a torque or strain sensor.

14. A method of operating an acoustic wave device according to any one of the preceding claims, comprising applying an electrical field to said electrode arrangement (18) to generate therein multiple lamb wave modes and evaluating an output signal of said acoustic wave device to monitor at least one parameter of a high-order mode Lamb wave with quasi-zero surface components (QZ-PAW).

15. The method according to claim 14, wherein said output signal monitoring comprises detecting changes of at least one of a phase shift, frequency shift, time delay and phase velocity shift of the output signal relating to a high-order mode Lamb wave with quasi-zero surface components.
